# EUROPEAN PATENT APPLICATION

(11) **EP 3 790 139 A1**
(43) Date of publication of application: **10.03.2021**
(21) Application number: 19195116.9
(22) Date of filing: 03.09.2019
(51) Int. Cl.: H02H 7/18, G01R 31/36, H02J 7/00

(54) **BATTERY MANAGEMENT AND PROTECTION SYSTEM**

(71) Applicant: ABB Schweiz AG, 5400 Baden (CH)
(72) Inventor: Guggisberg, Beat, 5417 Untersiggenthal (CH); Pfister, Stefan, 8953 Dietikon (CH); Wicki, Stefan, 5702 Niederlenz (CH)
(74) Representative: Qip Patentanwälte Dr. Kuehn & Partner mbB

(57) **Abstract**

The invention relates to battery management and protection system (100) for a battery (108) composed of battery cells (110). The battery management and protection system (100) comprises a battery management device (104) adapted for receiving cell voltage measurement signals (121), for determining whether cell voltages determined from the cell voltage measurement signals (121) are outside a first voltage range (204) and for outputting a tripping signal (116) for disconnecting the battery (108) from a load and/or a power supply when at least one of the cell voltages is outside the first voltage range (204). Further, battery management and protection system (100) comprises a protection circuit (102) adapted for receiving the cell voltage measurement signals (121), for determining whether cell voltages determined from the cell voltage measurement signals (121) are outside a second voltage range (210) including the first voltage range (204) and for outputting the tripping signal (116) when at least one of the cell voltages is outside the second voltage range (210).

## Description

### FIELD OF THE INVENTION

The invention relates to the field of battery management systems. In particular, the invention relates to a battery management and protection system as well as to a method, a computer program and a computer-readable medium for operating such a battery management and protection system.

### BACKGROUND OF THE INVENTION

For monitoring and protecting batteries, as used, for example, in hybrid or electrical vehicles, a battery management system with certified safety features may be used. These intelligent systems may involve SIL (Safety Integrity Level) or ASIL (Automotive Safety Integrity Level) certified hardware such as microcontrollers, software, firmware or dedicated hardware which interrupts current locally using an electronic switch.

Another variant is to use dedicated integrated circuits that protect each cell of a battery package. For example, such circuits may be used in packages with up to six cells in series. The circuits control a local switch, typically a MOSFET, which cuts off the cells from a load or a power supply when necessary.

If components of such certified systems are modified, recertification is usually required. Also, the use of local switches may affect scalability of the system.

CN 105811495 A describes a safety protection device for a lithium battery for a vehicle. The safety protection device realizes the function of overvoltage and undervoltage protection by using a superordinate power switch for disconnecting the lithium battery from a load or a power supply.

### DESCRIPTION OF THE INVENTION

It is an objective of the invention to provide a battery management and protection system which combines both redundancy of safety-relevant features and scalability without requiring recertification when some of the safety-relevant features are modified.

This objective is achieved by the subject-matter of the independent claims. Further exemplary embodiments are evident from the dependent claims and the following description.

Briefly summarized, a protection circuit, which may be a separate piece of hardware, is added to a battery management system in order to monitor cell voltages and/or temperatures redundantly. These two properties may be of paramount importance to guarantee safe operation of the battery cells. The protection circuit may be implemented in hardware only and/or without any dependencies on the actual battery management system which controls these properties. Thus, the safety level of the whole system may only be certified once, and the certification may remain the same for different hardware, software and/or firmware versions of the battery management system as all of the relevant safety features are additionally implemented in the protection circuit which remains unchanged. As a result, the protection circuit may facilitate scalability and adaptation to different battery configurations.

In other words, the protection circuit may be adapted to monitor all battery cells attached to it and to open one or more switches in an emergency trip line accordingly. This may be to prevent further charging, discharging and/or heating of the battery. As the trip line and/or the one or more switches in the trip line may be opened by any attached device, the system may be easily scalable.

In the case wherein the protection circuit is completely independent of the battery management system, which controls voltages and temperatures, the battery management system may be modified without requiring any recertification regarding safety-relevant features. In this case, the protection circuit may be combined with any (for example even unknown) battery management system.

A first aspect of the invention relates to a battery management and protection system for a battery composed of battery cells. The battery management and protection system comprises a battery management device adapted for receiving cell voltage measurement signals, for determining whether cell voltages determined from the cell voltage measurement signals are outside a first voltage range and for outputting a tripping signal for disconnecting the battery from a load and/or a power supply when at least one of the cell voltages is outside the first voltage range. Furthermore, the battery management and protection system comprises a protection circuit adapted for receiving the cell voltage measurement signals, for determining whether cell voltages determined from the cell voltage measurement signals are outside a second voltage range including the first voltage range and for outputting the tripping signal when at least one of the cell voltages is outside the second voltage range.

The battery may be, for example, a lithium battery. The battery cells may be interconnected in series or in parallel. The battery cells may be connected individually to the protection circuit and/or the battery management device. The battery, the protection circuit and the battery management device may each be connected to an emergency trip line for disconnecting the battery from the load and/or the power supply. The trip line may comprise one or more central (power) switches which may be controlled by the protection circuit and/or the battery management device and/or any other device attached to it. In particular, the protection circuit and the battery management device may be adapted for controlling the one or more switches independently of each other.

The battery management device may comprise hardware and/or software modules for protecting the battery from operating outside the first voltage range. The first voltage range may be a normal operating range of the battery. The battery management device may be adapted for monitoring a current, a voltage and/or a temperature of individual battery cells. Additionally or alternatively, the battery management device may be adapted for equalizing voltages of different battery cells and/or for calculating and/or reporting secondary data regarding a state of the battery. For example, the battery management device may comprise a processor for performing a corresponding computer program. It is also possible that the battery management device is connected to a bus system of a vehicle, such as a CAN bus system (CAN = Controller Area Network) of a hybrid or electrical vehicle, in order to receive and process signals from a superordinate controller of the vehicle.

The protection circuit may be a hardware-based circuit with a very high safety integrity level. For example, the protection circuit may comprise exclusively, or at least mostly, hardware components such as comparators, a logic and/or one or more galvanically isolated switches, in particular one or more relays. The second voltage range may be a range within which safe operation of the battery can be ensured.

The cell voltage measurement signals may be raw voltage signals from the battery cells and/or amplified and/or filtered signals determined from the raw voltage signals.

The battery management device and the protection circuit may be combined on a single electronic board or implemented on two separate electronic boards.

A tripping signal may be a signal for controlling a switch in the trip line, e. g. for opening a galvanically isolated switch or when one or more cell voltages are outside the first voltage range and/or the second voltage range, such that further charging, discharging and/or heating of the battery is prevented.

According to an embodiment of the invention, the battery management device comprises a processor for performing a computer program for receiving the cell voltage measurement signals and/or for determining whether the cell voltages are outside the first voltage range and/or for outputting the tripping signal. In other words, the battery management device may be realized as a programmable computer. For example, the processor may be part of a microprocessor, microcontroller or a system on a chip (SoC). This may allow the battery management device to be adapted easily to different configurations.

According to an embodiment of the invention, the protection circuit comprises hardware components for receiving the cell voltage measurement signals and/or for determining whether the cell voltages are outside the second voltage range and/or for outputting the tripping signal. Such hardware components maybe, for example, comparators, a logic circuit and/or one or more switches. The comparators may be connected individually to the battery cells and may be adapted for filtering and/or amplifying cell voltages. A comparator may be seen as a comparator circuit. The logic circuit may be adapted for processing the cell voltage measurement signals based on a Boolean function. For example, the logic circuit may receive the cell voltage measurement signals from the comparators and compare each of the received cell voltage measurement signals with an upper threshold value and a lower threshold value, both values defining the second voltage range. Depending on whether a cell voltage measurement signal is either above the upper threshold value or below the lower threshold value, the logic circuit may output the tripping signal. Additionally, the logic circuit may be adapted for receiving cell voltage measurement signals from the battery management device. The comparator circuits, the protection circuit and/or the logic circuit may be realized completely in hardware without any software components and/or any dependencies on software components. Thus, the protection circuit and/or the logic circuit may reach a very high security level.

According to an embodiment of the invention, the protection circuit comprises comparators for amplifying cell voltages. As already mentioned, a comparator may be adapted to compare two cell voltages and output a digital signal indicating which one of the two cell voltages is larger. For example, a comparator may have two analogue input terminals V₊ and V₋ and one binary digital output V₀. The output V₀ may be 1 if V₊ > V₋ and 0 if V₊ < V₋. The comparators may be open drain or push-pull comparators. For example, the protection circuit may have two or more comparators each of which may be connected to one of the battery cells. Additionally, the protection circuit may have a comparator for amplifying temperature measurement signals of a temperature sensor for measuring a temperature of the battery, as described in more detail below.

According to an embodiment of the invention, the protection circuit may be adapted for delaying the tripping signal by a predefined delay time. The delay time may be a period of time between receiving the cell voltage measurement signals and outputting the tripping signal. For example, the delay time may be between 0.1 s and 10 s. This is to avoid that the tripping signal is output when cell voltages exceed the second voltage range only for relatively short amounts of time. Thus, frequent interruptions of the trip line due to short-term voltage fluctuations can be avoided.

According to an embodiment of the invention, the battery management and protection system may further comprise a temperature sensor for measuring a temperature of the battery. The battery management device may be adapted for receiving temperature measurement signals, for determining whether temperatures determined from the temperature measurement signals are outside a first temperature range and for outputting the tripping signal when at least one of the temperatures is outside the first temperature range. Likewise, the protection circuit may be adapted for receiving the temperature measurement signals, for determining whether temperatures determined from the temperature measurement signals are outside a second temperature range including the first temperature range and for outputting the tripping signal when at least one of the temperatures is outside the second temperature range. The temperature sensor may be attached to the battery. It is also possible that the temperature sensor comprises two or more sensor units each of which may be coupled to one of the battery cells in order to measure an individual temperature of the battery cells. The protection circuit and/or the battery management device may be adapted for processing the temperature measurement signals in parallel to the cell voltage measurement signals. For example, the protection circuit may be adapted for processing the temperature measurement signals in the same manner as the cell voltage measurement signals by using, for example, a comparator and a logic circuit. This allows for a redundant monitoring of battery temperature.

According to an embodiment of the invention, the battery management device may be adapted for outputting a signal to the protection circuit. The signal may be a cell voltage measurement signal, a temperature measurement signal or a tripping signal. For example, the battery management device may be adapted for outputting the signal to a logic of the protection circuit for further processing of the signal. In particular, the signal received from the battery management device may be used to validate a signal generated by the protection circuit.

According to an embodiment of the invention, the protection circuit comprises a galvanically isolated switch adapted for operating a power switch for disconnecting the battery from the load and/or the power supply. The galvanically isolated switch may be operated by the tripping signal. The power switch may be integrated in the trip line. The galvanically isolated switch may be realized as a fail-safe hardware contact. It also may be that the protection circuit comprises more than one galvanically isolated switch. This embodiment makes it possible to control the power switch by a low-power tripping signal.

According to an embodiment of the invention, the battery management device may be adapted for outputting the tripping signal to the galvanically isolated switch. The battery management device may be adapted for outputting the tripping signal either directly to the galvanically isolated switch or indirectly by outputting a cell voltage measurement signal to a logic circuit of the protection circuit. The logic circuit may then output the tripping signal based on the cell voltage measurement signal of the battery management device. This eliminates the need for an additional switch to interrupt the trip line.

According to an embodiment of the invention, the battery management device may be adapted for operating a power switch for disconnecting the battery from the load and/or the power supply. A power switch may be a switch designed to switch high currents, such as currents higher than 1 A or higher than 10 A, from a load or a power supply. For example, the power switch may have a spring mechanism to make sure that the transition between on and off is as short as possible. For example, the power switch may be a switch integrated in the trip line. The power switch may be operated by the battery management device as well as by the protection circuit. In particular, the power switch may be operated independently by the battery management device and the protection circuit. The power switch may be placed at an arbitrary location inside or outside the battery and/or the battery management and protection system, which allows for easy modification or replacement of the power switch.

According to an embodiment of the invention, the battery management device may be adapted for receiving a controller signal from a superordinate controller and for outputting the tripping signal based on the controller signal. A superordinate controller may be, for example, an electronic control unit (ECU) of a vehicle. The controller may be connected to the battery management device via a CAN bus. For example, the controller signal may indicate that the vehicle is in a parking position or has an accident. In this case, the battery management device may disconnect the battery by outputting the tripping signal based on the controller signal. This avoids unwanted discharging of the battery or damages due to a connected battery in case of an accident.

According to an embodiment of the invention, the protection circuit may be adapted for detecting a wiring failure in a connection between the battery cells and the protection circuit and for outputting the tripping signal based on the detected wiring failure. For example, the protection circuit may comprise a dedicated detection circuit adapted for detecting wiring failures such as, for example, short-to-battery, short-to-ground, open-circuit or short-circuit faults. Alternatively, the detection circuit may be realized as a separate circuit. Thus, battery damages due to wiring failures can be avoided.

A further aspect of the invention relates to a method of operating a battery management and protection system as described above and below. The method comprises the following steps: receiving the cell voltage measurement signals; determining whether cell voltages determined from the cell voltage measurement signals are outside the first voltage range and/or outside the second voltage range; outputting the tripping signal when at least one of the cell voltages is outside the first voltage range and/or outside the second voltage range. In particular, one or more of the following steps may be performed only by hardware: receiving the cell voltage measurement signals; determining whether cell voltages determined from the cell voltage measurement signals are outside the second voltage range; outputting the tripping signal when at least one of the cell voltages is outside the second voltage range.

A further aspect of the invention relates to a computer program which, when being executed in a processor, is adapted for performing the method as described above and below.

A further aspect of the invention relates to a computer readable medium in which such a computer program is stored. A computer-readable medium may be a floppy disk, a hard disk, an USB (Universal Serial Bus) storage device, a RAM (Random Access Memory), a ROM (Read Only Memory), an EPROM (Erasable Programmable Read Only Memory) or a FLASH memory. A computer readable medium may also be a data communication network, e. g. the Internet, which allows downloading a program code. In general, the computer-readable medium may be a non-transitory or transitory medium.

It has to be understood that features of the battery management and protection system as described above and below may be features of the method, the computer program and/or the computer readable medium as described above and below.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a battery management and protection system according to an embodiment of the invention.
Fig. 2 shows a diagram with cell voltage levels used by the battery management and protection system of Fig. 1 and a corresponding trip line signal.
Fig. 3 shows a flow diagram for a method for operating a battery management and protection system according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

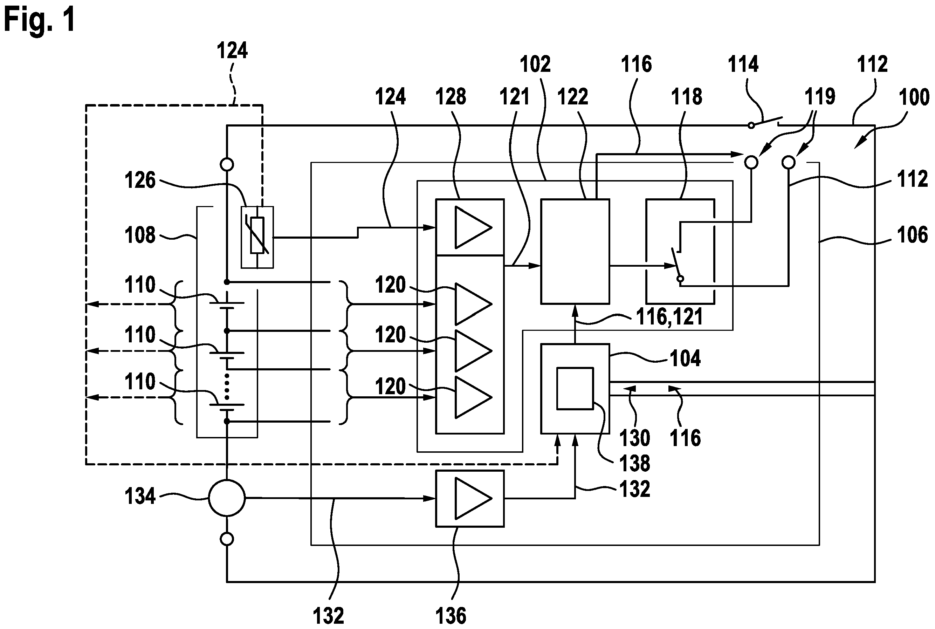

Fig. 1 schematically shows a battery management and protection system 100 according to an embodiment of the invention. The battery management and protection system 100 comprises a protection circuit 102 and a battery management device 104. In this example, both the protection circuit 102 and the battery management device 104 are realized on an electronic board 106, e. g. a printed circuit board. Alternatively, the protection circuit 102 and the battery management device 104 may be realized on separate electronic boards. The battery management and protection system 100 is connected to a battery 108 for storing electrical energy. The battery 108 comprises of a plurality of battery modules or battery cells 110 which, exemplarily, are connected to each other in series. Each of the battery cells 110 is connected to the protection circuit 102 as well as to the battery management device 104. Further, the battery 108, the protection circuit 102 and the battery management device 104 are each connected to a trip line 112 having a central power switch 114.

Both the protection circuit 102 and the battery management device 104 are adapted for measuring voltages of the battery cells 110. In order to ensure that the battery 108 is operating in a safe voltage range, the battery management device 104 compares the measured cell voltages to a first voltage range which corresponds to a normal operating range of the battery 108. For the same purpose, the protection circuit 102 compares the measured cell voltages to a second voltage range which corresponds to a greater than normal, yet safe range of the battery 108. If any of the measured cell voltages exceeds the bounds of the respective ranges, a tripping signal 116 is generated by the protection circuit 102 and/or the battery management device 104. The tripping signal 116 opens the power switch 114 so that the battery 108 is disconnected from a load or a power supply.

According to this embodiment, the power switch 114 is operated by an electronically controllable galvanically isolated switch 118 connected to the power switch 114 by terminals 119. The galvanically isolated switch 118 may be part of the protection circuit 102.

In short, the purpose of both the protection circuit 102 and the battery management device 104 is to protect the battery 108 from over voltage, under voltage and, optionally, over temperature on a cell level and a battery module level, as described in more detail below.

In order to measure the cell voltages, the protection circuit 102 may comprise a plurality of comparators 120 each of which may be connected to one of the battery cells 110. The comparators 120 may form a cell voltage filtering and measurement circuit which may output cell voltage measurement signals 121 comprising filtered cell voltages. The protection circuit 102 may further comprise a dedicated protection logic (circuit) 122 which may be adapted for receiving the cell voltage measurement signals 121 from the comparators 120 and for controlling the galvanically isolated switch 118 depending on whether the filtered cell voltages are inside or outside the second voltage range.

The cell voltage measurement signals 121 may be binary signals. Alternatively, the cell voltage measurement signals 121 may be voltage signals. In this case, the comparators 120 may be located in the protection logic 122.

Optionally, the protection circuit 102 is adapted for receiving temperature measurement signals 124 from a temperature sensor 126 which is coupled to the battery 108. The temperature sensor 126 may comprise a plurality of sensor units which may be adapted for monitoring individual temperatures of the battery cells 110. Accordingly, the protection circuit 102 may have an additional comparator 128 which serves as an amplification system for amplifying the received temperature measurement signals 124. The amplified temperature measurement signals 124 may then be processed by the protection logic 122 in a similar manner to the cell voltage measurement signals 121. In particular, temperatures included in the amplified temperature measurement signals 124 may be compared to a predefined temperature range, which ensures safe operation of the battery 108 in terms of temperature. When one or more of the temperatures are outside the temperature range, the tripping signal 116 may be output in order to avoid over heating of the battery 108.

Alternatively or additionally, the (for example amplified) temperature measurement signals 124 may be received by the battery management device 104. In this case, the battery management device 104 may be adapted for comparing the (amplified) temperature measurement signals 124 to another temperature range in order to determine whether the temperatures included in the (amplified) temperature measurement signals 124 are outside the other temperature range. When one or more of the temperatures are outside the other temperature range, the battery management device 104 may output the tripping signal 116 accordingly. The temperature ranges used by the protection circuit 102 and the battery management device 104 may differ from each other. In particular, the temperature range used by the protection circuit 102 may include the other temperature range used by the battery management device 104. In other words, the protection circuit 102, in comparison to the battery management device 104, allows the battery 108 to be operated at higher, yet still safe temperatures.

The protection circuit 102 may additionally be adapted for detecting a wiring failure in an electrical connection between the battery cells 110 and the protection circuit 102. In particular, the protection circuit 102 may be adapted for outputting the tripping signal 116 when a wiring failure is detected.

All of the components forming the protection circuit 102 may be realized in hardware in absence of any software. In particular, the protection circuit 102 may be realized as a standalone safety-certified circuit with very high safety integrity levels.

According to an embodiment, the protection logic 122 is also connected to the battery management device 104 in order to process a signal generated by the battery management device 104, such as, for example, the tripping signal 116 or the cell voltage measurement signals 121, which the battery management device 104 may receive from another comparator connected to the battery cells 110. The protection logic 122 may use the tripping signal 116 output by the battery management device 104 to operate the galvanically isolated switch 118. Alternatively or additionally, the battery management device 104 may be adapted for operating the power switch 114 directly and/or independently of the protection circuit 102.

According to another embodiment, the battery management device 104 receives a controller signal 130 from a controller such as, for example, an electronic control unit of a hybrid or electrical vehicle. In particular, the battery management device 104 may receive the controller signal 130 through a CAN bus interface. The battery management device 104 may use the controller signal 130 to generate the tripping signal 116. Additionally or alternatively, the battery management device 104 may send measurement data or secondary data regarding the battery 108 to the controller.

As shown in Fig. 1, the battery management device 104 may also be adapted for monitoring a current of the battery 108 through current measurement signals 132 output by a current measurement device 134 connected to the battery 108. Before being received in the battery management device 104, the current measurement signals 132 may be conditioned by a current measurement and conditioning circuit 136 integrated in the electronic board 106. Accordingly, the battery management device 104 may be adapted for outputting the tripping signal 116 depending on the current measurement signals 132. More precisely, the battery management device 104 may be adapted for determining whether currents determined from the current measurement signals 132 are outside a safe current range which ensures safe operation of the battery 108. When at least one of the currents is outside the safe current range, the battery management device 104 may output the tripping signal 116.

The battery management device 104 may be adapted for performing one or more computer programs in order to perform one or more of the operations described above. Accordingly, the battery management device 104 may be equipped with a processor 138 or other hardware components required to perform such computer programs.

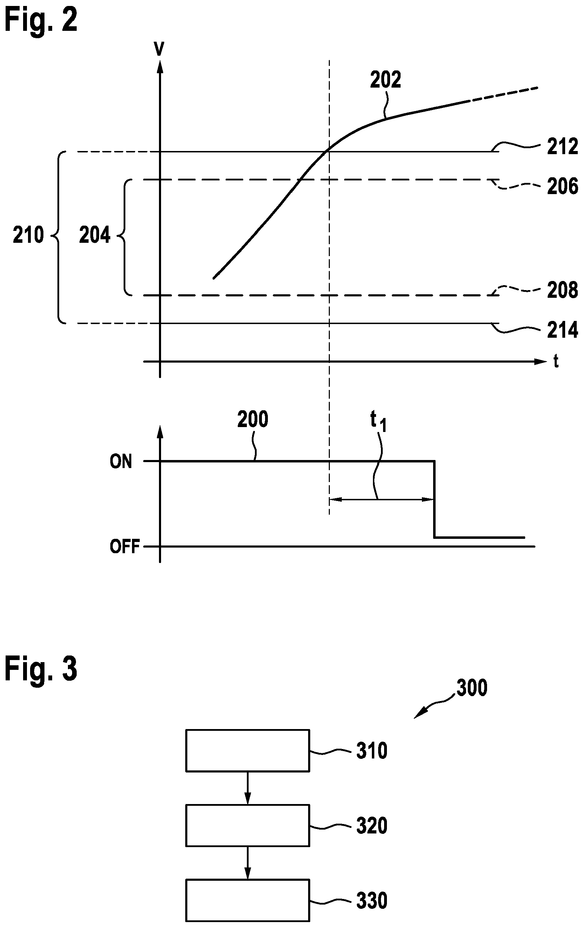

Fig. 2 shows a diagram with cell voltage levels used by the battery management and protection system 100 of Fig. 1 and a corresponding trip line signal 200. The diagram shows a rising cell voltage curve 202 as well as the first voltage range 204 defined by a maximum operational level 206 and a minimum operational level 208 and the second voltage range 210 defined by an overvoltage protection level 212 and an undervoltage protection level 214. The second voltage range 210 encloses the first voltage range 204. Below the cell voltage curve 202, the trip line signal 200, which may be a current signal, is shown.

As long as the cell voltage remains within the second voltage range 210, the power switch 114 remains in an ON position which corresponds to a closed state of the power switch 114. As soon as the cell voltage reaches the overvoltage protection level 212, the tripping signal 116 is output.

According to the embodiment shown in Fig. 2, a timer (which may be implemented in hardware) is started when the cell voltage exceeds the overvoltage protection level 212. In this case, the tripping signal 116 is only output after a predefined delay time ti.

As soon as the tripping signal 116 is output, the power switch 114 is switched to an OFF position which corresponds to an open state of the power switch 114. In this state, the battery 108 is disconnected from any load or power supply.

As already described above, the tripping signal 116 may also be output when the cell voltage exceeds the maximum operational level 206 and/or falls below the undervoltage protection level 214 and/or the minimum operational level 208.

Fig. 3 shows a flow diagram for a method 300 for operating a battery management and protection system according to an embodiment of the invention. The method 300 may be performed for operating the battery management and protection system 100 of Fig. 1.

In a first step 310 the cell voltage measurement signals 121 are received respectively in the protection circuit 102 and the battery management device 104. In a second step 320 cell voltages are determined from the received cell voltage measurement signals 121. Further, the determined cell voltages are compared to the first voltage range 204 in the battery management device 104 as well as to the second voltage range 210 in the protection circuit 102. When at least one of the cell voltages is outside the first voltage 204, the tripping signal 116 is output by the battery management device 104. Alternatively or additionally, the tripping signal 116 is output by the protection circuit 102 when at least one of the cell voltages is outside the second voltage 210. In either case, the battery 108 is disconnected from any load or power supply and therefore protected against damages from over voltage, under voltage or, optionally, over temperature.

In particular, all of the steps involving the protection circuit 102 may be performed without any software and/or may be implemented in hardware. This reliably ensures safe operation of the battery 108 in different sorts of applications such as, for example, railway, bus, mining, marine or stationary applications.

The use of the protection circuit 102 such as described above, which may be realized as a stand-alone (hardware only) circuit or integrated in a battery management system, allows for a very reliable and fail-safe design with high overall system availability. Such a design is also very robust against false alarms.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- t₁: delay time
- 100: battery management and protection system
- 102: protection circuit
- 104: battery management device
- 106: electronic board
- 108: battery
- 110: battery cell
- 112: trip line
- 114: power switch
- 116: tripping signal
- 118: galvanically isolated switch
- 119: terminal
- 120: comparator
- 121: cell voltage measurement signal
- 122: protection logic
- 124: temperature measurement signal
- 126: temperature sensor
- 128: additional comparator
- 130: controller signal
- 132: current measurement signal
- 134: current measurement device
- 136: current measurement and conditioning circuit
- 138: processor
- 200: trip line signal
- 202: cell voltage curve
- 204: first voltage range
- 206: maximum operational level
- 208: minimum operational level
- 210: second voltage range
- 212: overvoltage protection level
- 214: undervoltage protection level
- 300: method of operating a battery management and protection system
- 310: step of receiving
- 320: step of determining
- 330: step of outputting

## Claims

1. A battery management and protection system (100) for a battery (108) composed of battery cells (110), the battery management and protection system (100) comprising:
a battery management device (104) adapted for receiving cell voltage measurement signals (121), for determining whether cell voltages determined from the cell voltage measurement signals (121) are outside a first voltage range (204) and for outputting a tripping signal (116) for disconnecting the battery (108) from a load and/or a power supply when at least one of the cell voltages is outside the first voltage range (204);
a protection circuit (102) adapted for receiving the cell voltage measurement signals (121), for determining whether cell voltages determined from the cell voltage measurement signals (121) are outside a second voltage range (210) including the first voltage range (204) and for outputting the tripping signal (116) when at least one of the cell voltages is outside the second voltage range (210).

2. The battery management and protection system (100) of claim 1,
wherein the battery management device (104) comprises a processor (138) for performing a computer program for receiving the cell voltage measurement signals (121) and/or for determining whether the cell voltages are outside the first voltage range (204) and/or for outputting the tripping signal (116).

3. The battery management and protection system (100) of claim 1 or 2,
wherein the protection circuit (102) comprises hardware components (120, 128, 122, 118, 119) for receiving the cell voltage measurement signals (121) and/or for determining whether the cell voltages are outside the second voltage range (210) and/or for outputting the tripping signal (116).

4. The battery management and protection system (100) of one of the previous claims,
wherein the protection circuit (102) comprises comparators (120, 128) for amplifying cell voltages.

5. The battery management and protection system (100) of one of the previous claims,
wherein the protection circuit (102) is adapted for delaying the tripping signal (116) by a predefined delay time (ti).

6. The battery management and protection system (100) of one of the previous claims, further comprising a temperature sensor (126) for measuring a temperature of the battery (108),
wherein the battery management device (104) is adapted for receiving temperature measurement signals (124), for determining whether temperatures determined from the temperature measurement signals (124) are outside a first temperature range and for outputting the tripping signal (116) when at least one of the temperatures is outside the first temperature range;
wherein the protection circuit (102) is adapted for receiving the temperature measurement signals (124), for determining whether temperatures determined from the temperature measurement signals (124) are outside a second temperature range including the first temperature range and for outputting the tripping signal (116) when at least one of the temperatures is outside the second temperature range.

7. The battery management and protection system (100) of one of the previous claims, wherein the battery management device (104) is adapted for outputting a signal (116, 121) to the protection circuit (102).

8. The battery management and protection system (100) of one of the previous claims,
wherein the protection circuit (102) comprises a galvanically isolated switch (118) adapted for operating a power switch (114) for disconnecting the battery (108) from the load and/or the power supply;
wherein the galvanically isolated switch (118) is operated by the tripping signal (116).

9. The battery management and protection system (100) of claim 7 and 8,
wherein the battery management device (104) is adapted for outputting the tripping signal (116) to the galvanically isolated switch (118).

10. The battery management and protection system (100) of one of the previous claims,
wherein the battery management device (104) is adapted for operating a power switch (114) for disconnecting the battery (108) from the load and/or the power supply.

11. The battery management and protection system (100) of one of the previous claims,
wherein the battery management device (104) is adapted for receiving a controller signal (130) from a superordinate controller and for outputting the tripping signal (116) based on the controller signal (130).

12. The battery management and protection system (100) of one of the previous claims,
wherein the protection circuit (102) is adapted for detecting a wiring failure in a connection between the battery cells (110) and the protection circuit (102) and for outputting the tripping signal (116) based on the detected wiring failure.

13. A method (300) of operating a battery management and protection system (100) according to one of the previous claims, the method (300) comprising:
receiving (310) the cell voltage measurement signals (121);
determining (320) whether cell voltages determined from the cell voltage measurement signals (121) are outside the first voltage range (204) and/or outside the second voltage range (210);
outputting (330) the tripping signal (116) when at least one of the cell voltages is outside the first voltage range (204) and/or outside the second voltage range (210).

14. A computer program which, when being executed on a processor (138), is adapted for performing at least one of the steps (310, 320, 330) of the method (300) of claim 13.

15. A computer readable medium in which a computer program according to claim 14 is stored.
